# EUROPEAN PATENT APPLICATION

(11) **EP 2 251 908 A2**
(43) Date of publication of application: **17.11.2010**
(21) Application number: 10150014.8
(22) Date of filing: 04.01.2010
(51) Int. Cl.: H01L 31/0203, H01L 31/0216

(54) **Thin film solar cell and fabrication method thereof**

(30) Priority: 12.05.2009 TW 98115711
(71) Applicant: Tsai, Chin-Yao, Nansi Township, Tainan County 715 (TW)
(72) Inventor: Tsai, Chin-Yao, Nansi Township, Tainan County 715 (TW)
(74) Representative: Chamberlain, Alan James

(57) **Abstract**

A thin film solar cell having an active area and a dead area is provided. The thin film solar cell includes a first substrate, a first conductive layer, an photovoltaic layer, a second conductive layer, a first passivation layer, and a second passivation layer. The first conducting layer, the photovoltaic layer, the second conductive layer, and the first passivation layer are respectively disposed on the first substrate, the first conductive layer, the photovoltaic layer, and the second conductive layer, and all of them are located in the active area. The second passivation layer is disposed on a peripheral of the photovoltaic layer and located in the dead area, so as to avoid the photovoltaic layer from contacting with moisture in air. A fabrication method of the thin film solar cell is also provided.

## Description

### BACKGROUND OF THE INVENTION

### Field of the Invention

The present invention generally relates to a solar cell and a fabrication method thereof, and more particularly, to a thin film solar cell capable of avoiding infiltration of moisture in air and a fabrication method thereof.

### Description of Related Art

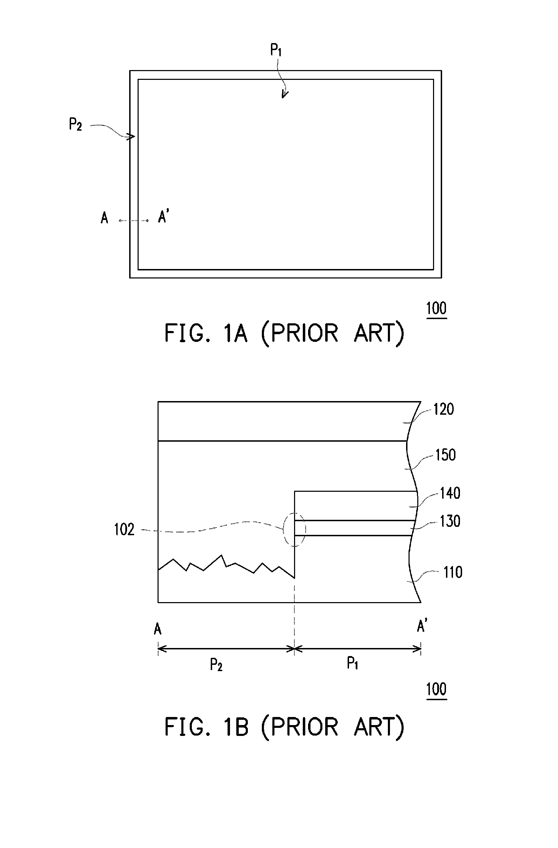

FIG. 1A is a top view of a conventional thin film solar cell. FIG. 1B is a cross-sectional view of the thin film solar cell along the line AA' in FIG. 1A. For convenience of description, FIG. 1A simply illustrates the top view of films on a first substrate in FIG. 1B but ignores a second substrate and an adhesive between the first substrate and the second substrate. Referring FIG. 1A and FIG. 1B, the thin film solar cell 100 has an active area P1 and a dead area P2. Wherein, a photovoltaic layer 130 disposed in the active area P1 transforms photonic energy into electric energy. Furthermore, a passivation layer 140, such as a white paint, is disposed on the photovoltaic layer 130 and used to protect the photovoltaic layer 130 and electrode layers (not shown) on the sides of the photovoltaic layer 130.

Generally, in the conventional thin film solar cell 100, the electrode layer, the photovoltaic layer 130, the electrode layer, and the passivation layer 140 are disposed on the first substrate 110 in sequence. During the process of stacking these films, they are patterned by using laser scribing processes to manufacturing a plurality of sub-cells in series.

Next, after completing the manufacture of the above-described films, a process for insulating is proceeded to a peripheral of the first substrate 110, so as to form the dead area P2 shown in FIG. 1A and FIG. 1B. Thereafter, the first substrate 110 and a second substrate 120 are packaged with an adhesive 150, so that the thin film solar cell 100 shown in FIG. 1B is finished.

In the thin film solar cell 100 shown in FIG. 1B, there is no passivation layer, such as the above-described white paint, disposed on the peripheral of the photovoltaic layer 130 and the electrode layers on the sides of the photovoltaic layer 130, such as an area 102 shown in FIG. 1B. Accordingly, moisture in air is easy to contact with the photovoltaic layer and the electrode layers by infiltrating into the thin film solar cell 100 through two sides thereof. As a result, leakage current is generated due to the moisture in air, and further an electrical property of the thin film solar cell 100 is affected thereby. It is dangerous for users, and the thin film solar cell's life is reduced.

### SUMMARY OF THE INVENTION

Accordingly, one embodiment of the present invention provides a thin film solar cell capable of effectively avoiding infiltration of moisture in air and having a good electrical property.

One embodiment of the present invention provides a fabrication method of a thin film solar cell, by disposing insulating materials on a peripheral of an photovoltaic layer, to effectively avoid infiltration of moisture in air, so as to have the above-described advantage.

One embodiment of the present invention provides a thin film solar cell having an active area and a dead area. The thin film solar cell includes a first substrate, a first conductive, a photovoltaic layer, a second conductive layer, a first passivation layer, and a second passivation layer. The first conductive layer is disposed on the first substrate and located in the active area. The photovoltaic layer is disposed on the first conductive layer and located in the active area. The second conductive layer is disposed on the photovoltaic layer and located in the active area. The first passivation layer is disposed on the second conductive layer and located in the active area. The second passivation layer is disposed on a peripheral of the photovoltaic layer and located in the dead area to avoid the photovoltaic layer from contacting with moisture in air.

In an embodiment of the present invention, a material of the second passivation layer is an insulating material.

In an embodiment of the present invention, the thin film solar cell further includes a second substrate and an adhesion layer, wherein the adhesion layer covers the first passivation layer and the second passivation layer, and is located between the first substrate and the second substrate to package the first substrate and the second substrate.

In an embodiment of the present invention, a material of the adhesion layer includes EVA, PVB, Poly Olefin, or PU.

In an embodiment of the present invention, the photovoltaic layer is a silicon thin film, a III-V compound semiconductor thin film, a II-VI compound semiconductor thin film, or an organic compound semiconductor thin film. In an embodiment of the present invention, a material of the silicon thin film includes at least one of a-Si, µc-Si, a-SiGe, µc-SiGe, a-SiC, and µc-SiC, and the silicon thin film is a tandem silicon thin film or a triple silicon thin film. In an embodiment of the present invention, a material of the III-V compound semiconductor thin film includes GaAs, InGaP, or a combination thereof. In an embodiment of the present invention, a material of the II-VI compound semiconductor thin film includes CIS, CIGS, CdTe, or a combination thereof. In an embodiment of the present invention, a material of the organic compound semiconductor thin film includes Poly(3-hexylthiophene) ( P3HT) and a PCBM mixture.

In an embodiment of the present invention, the first conductive layer is a transparent conductive layer, and the second conductive layer includes one of a reflecting layer and a transparent conductive layer. In an embodiment of the present invention, the second conductive layer is a transparent conductive layer, and the first conductive layer includes one of a reflecting layer and a transparent conductive layer.

One embodiment of the present invention provides a fabrication method of a thin film solar cell. The fabrication method includes following steps. First, a first substrate is provided. Next, a first conductive layer is formed on the first substrate. Thereafter, an photovoltaic layer is formed on the first conductive layer. Next, a second conductive layer is formed on the photovoltaic layer. Thereafter, a first passivation layer is formed on the second conductive layer. Next, a portion of the first conductive layer, a portion of the photovoltaic layer, a portion of the second conductive layer, and a portion of the first passivation layer located on a peripheral of the first substrate are removed to define an active region and a dead area on the first substrate. Thereafter, a second passivation layer located in the dead area is formed to cover a peripheral of the photovoltaic layer, so as to avoid the photovoltaic layer contacting moisture in air.

In an embodiment of the present invention, the fabrication method further includes a step of covering an adhesion layer on the first passivation layer and the second passivation layer to package the first substrate and a second substrate.

In an embodiment of the present invention, a method of forming the photovoltaic layer includes radio frequency plasma enhanced chemical vapor deposition (RF PECVD), very high frequency plasma enhanced chemical vapor deposition (VHF PECVD, or microwave plasma enhanced chemical vapor deposition (MW PECVD).

In an embodiment of the present invention, a method of forming the first passivation layer and the second passivation layer includes a process of screen printing, dry film lamination, or spin coating.

In an embodiment of the present invention, a method of defining the active region and the dead area on the first substrate includes a process of etching, sandblasting, edging, or laser scribing.

In an embodiment of the present invention, the step of forming the first conductive layer further includes a step of forming at least one of a transparent conductive layer and a reflecting layer on the first substrate, wherein the second conductive layer is a transparent conductive layer.

In an embodiment of the present invention, the step of forming the first conductive layer further includes a step of forming at least one of a transparent conductive layer and a reflecting layer on the first substrate, wherein the first conductive layer is a transparent conductive layer.

In view of the above, the second passivation layer covers a peripheral of the film structure composed of the first conductive layer, the photovoltaic layer, and the second conductive layer in the thin film solar cell of the embodiment consistent with the present invention. Accordingly, leakage current or bad films due to infiltration of moisture in air are avoided, so that the thin film solar cell has a relatively good electrical property. Moreover, a fabrication method of the thin film solar cell is also provided in the embodiment consistent with the present invention.

In order to make the aforementioned and other features and advantages of the present invention more comprehensible, several embodiments accompanied with figures are described in detail below.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.

FIG. 1A is a top view of a conventional thin film solar cell. FIG. 1B is a cross-sectional view of the thin film solar cell along the line AA' in FIG. 1A.

FIG. 2A is a top view of a thin film solar cell according to an embodiment consistent with the present invention.

FIG. 2B is a cross-sectional view of the thin film solar cell along the line BB' in FIG. 2A.

FIG. 3A through FIG. 3D are schematic cross-sectional views showing steps for manufacturing a thin film solar cell according to an embodiment consistent with the present invention.

FIG. 4A is a top view of a thin film solar cell according to another embodiment consistent with the present invention.

FIG. 4B is a cross-sectional view of the thin film solar cell along the line CC' in FIG. 4A.

FIG. 5A is a top view of a thin film solar cell according to an embodiment consistent with the present invention.

FIG. 5B is a cross-sectional view of the thin film solar cell along the line DD' in FIG. 5A.

FIG. 6A is a top view of a thin film solar cell according to an embodiment consistent with the present invention.

FIG. 6B is a cross-sectional view of the thin film solar cell along the line EE' in FIG. 6A.

### DESCRIPTION OF EMBODIMENTS

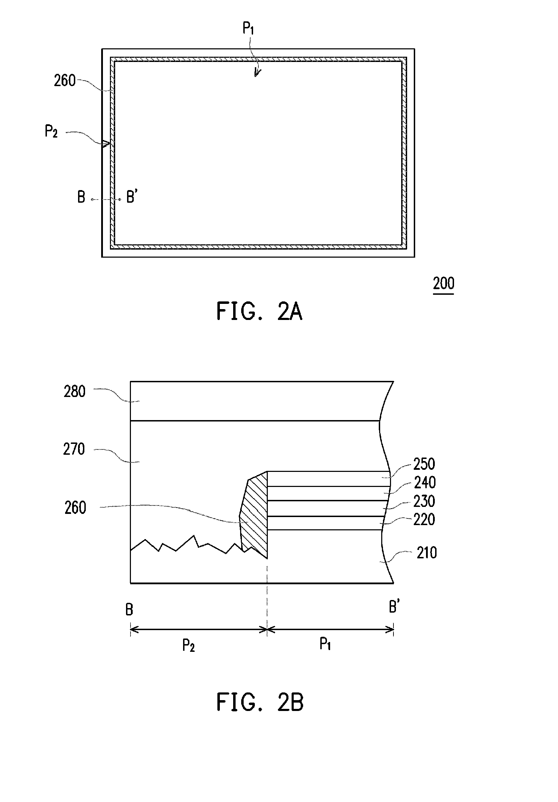

FIG. 2A is a top view of a thin film solar cell according to an embodiment consistent with the present invention. FIG. 2B is a cross-sectional view of the thin film solar cell along the line BB' in FIG. 2A. For convenience of description, FIG. 2A simply illustrates the top view of films on a first substrate in FIG. 2B but ignores a second substrate and an adhesion layer between the first substrate and the second substrate. Referring to FIG. 2A and FIG. 2B, the thin film solar cell 200 of the present embodiment has an active area P1 and a dead area P2. Furthermore, the thin film solar cell 200 includes the first substrate 210, a first conductive 220, an photovoltaic layer 230, a second conductive layer 240, a first passivation layer 250, and a second passivation layer 260.

The first conductive layer 220 is disposed on the first substrate 210 and located in the active area P2, as shown in FIG. 2B. In the present embodiment, the first substrate 210 may be a transparent substrate, such as a glass substrate. The first substrate 210 may be a transparent conductive layer, and a material thereof is at least one of indium tin oxide (ITO), indium zinc oxide (IZO), indium tin zinc oxide (ITZO), zinc oxide, aluminum tin oxide (ATO), aluminum zinc oxide (AZO), cadmium indium oxide (CIO), cadmium zinc oxide (CZO), GZO, and FTO.

In another embodiment (not shown), the first conductive layer 220 may be a reflecting layer (not shown) or a stack of the above-described transparent conductive layer and the reflecting layer, wherein the reflecting layer is located between the transparent conductive layer and the first substrate 210, and a material of the reflecting layer is a metal having high reflectivity, such as silver or aluminum.

The photovoltaic layer 230 is disposed on the first conductive layer 220 and located in the active area P1 as shown FIG. 2B. In the present embodiment, the photovoltaic layer 230 may be a silicon thin film, a III-V compound semiconductor thin film, a II-VI compound semiconductor thin film, or an organic compound semiconductor thin film. Specifically, a material of the silicon thin film, for example, includes at least one of a-Si, µc-Si, a-SiGe, µc-SiGe, a-SiC, and µc-SiC, and the silicon thin film may be a tandem silicon thin film or a triple silicon thin film. IIIA material of the III-V compound semiconductor thin film, for example, includes GaAs, InGaP, or a combination thereof. A material of the II-VI compound semiconductor thin film, for example, includes CIS, CIGS, CdTe, or a combination thereof. A material of the organic compound semiconductor thin film, for example, includes Poly(3-hexylthiophene) ( P3HT) and a PCBM mixture.

That is, the thin film solar cell 200 may adopt at least one film structure of an amorphous silicon thin film solar cell, a micro-crystalline or nano-crystalline silicon thin film solar cell, a tandem thin film solar cell, a triple thin film solar cell, a copper selenium cadmium (CIS) thin film solar cell, a copper gallium selenium cadmium (CIGS) thin film solar cell, a cadmium tellurium (CdTe) thin film solar cell, and an organic thin film solar cell.

In other words, the photovoltaic layer 230 of the present embodiment may be modified in consideration of the actual demands. The above description is merely exemplary. The thin film solar cell 200 may adopt another film structure of other thin film solar cells.

Furthermore, the second conductive layer 240 is disposed on the photovoltaic layer 230 and located in the active area P1 as shown FIG. 2B. In the present embodiment, the second conductive layer 240 may adopt the materials of the above-described transparent conductive layer, and thus, detail descriptions are omitted. In the present embodiment, the second conductive layer 240 may further include the reflecting layer, wherein the reflecting layer is located on the above-described transparent conductive layer. It should be noted that, when the second conductive layer 240 includes the reflecting layer, the first conductive layer 220 is simply the transparent conductive layer. On the contrary, when the first conductive layer 220 includes the reflecting layer, the second conductive layer 240 is simply the transparent conductive layer without the above-described reflecting layer. In another embodiment, the first conductive layer 220 and the second conductive layer 240 may both the transparent conductive layer without the above-described reflecting layer. In other words, it may be changed for different design requirements, such as a bifacial thin film solar cell or a single-facial thin film solar cell. The above description is merely exemplary, and the present invention is not limited herein. The first passivation layer 250 is disposed on the second conductive layer 240 and located in the active area P1. In the present embodiment, the first passivation layer 250 is used to avoid the second conductive layer 240 and the films therebelow from contacting with moisture in air which may lower the electrical property of the thin film solar cell 200. Generally, a material of the first passivation layer 250 is an insulating material. In another embodiment, the material of the first passivation layer 250 may be one of other insulating and transparent materials.

Moreover, the second passivation layer 260 is disposed on a peripheral of the photovoltaic layer 240 and located in the dead area P2 to avoid the photovoltaic layer 230 from contacting with moisture in air, as shown in FIG. 2B. In the present embodiment, since the second passivation layer 260 at least covers the peripheral of the film structure composed of the first conductive 220, the photovoltaic layer 230, and the second conductive layer 240 and contacts with the first passivation layer 250, the first conductive 220, the photovoltaic layer 230, and the second conductive layer 240 are avoided from contacting with moisture in air, as that the thin film solar cell 200 has a better electrical property.

In the present embodiment, materials of the first passivation layer 250 and the second passivation layer 260 may be the same transparent materials. That is, the second passivation layer 260 may adopt a suitable material, such as a white paint, for protecting. Similarly, the second passivation layer 260 may be one of other insulating and transparent material. For example, the insulating and transparent material may be SiOₓ, SiNₓ, SiNₓO_{y}, SiCₓ, hafnium oxide, AlOₓ, benzocyclobutane (BCB), cycloolefin, polyimide, polyamide, polyester, polyalcohols, polyethylene, polyphenylene, resin, polyether, polyketone, or a combinarion thereof. It should be noted that, in other embodiments, the second passivation layer 260 may adopt a material different from the first passivation layer 250.

The thin film solar cell 200 further includes a second substrate 280 and an adhesion layer 270, as shown in FIG. 2B. In the present embodiment, the adhesion layer 270 covers the first passivation layer 250 and the second passivation layer 260 and is located between the first substrate 210 and the second substrate 280. The adhesion layer 270 is used to package the first substrate 210 and the second substrate 280. Moreover, a material of the adhesion layer 270 may be an adhesive, such as EVA, PVB, Poly Olefin, or PU.

As known form above, since the thin film solar cell 200 includes the second passivation layer 260 covering the peripheral of the film structure composed of the first conductive 220, the photovoltaic layer 230, and the second conductive layer 240, the first conductive 220, the photovoltaic layer 230, and the second conductive layer 240 are avoided from contacting with moisture in air which causes leakage current or bad films affecting the electrical property of thin film solar cell 200. In other words, the thin film solar cell 200 including the second passivation layer 260 has a better the electrical property.

Moreover, a fabrication method of the above-described thin film solar cell is also provided in following.

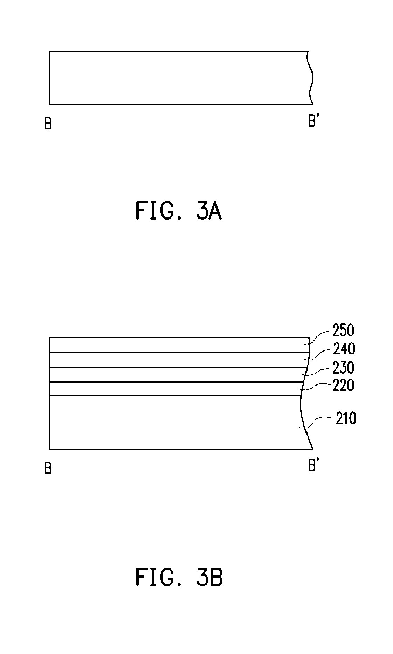

FIG. 3A through FIG. 3D are schematic cross-sectional views showing steps for manufacturing a thin film solar cell according to an embodiment consistent with the present invention. For convenience of description, FIG. 3A through FIG. 3D simply illustrate the schematic cross-sectional views of the thin film solar cell along the line BB' in FIG. 2A Referring to FIG. 3A, first of all, the first substrate 210 mentioned above is provided.

Next, the first conductive layer 220 mentioned above is formed on the first substrate 210, as shown in FIG. 3B. In the present embodiment, a method of forming the first conductive layer 220, for example, is sputtering, metal organic chemical vapor deposition (MOCVD), and evaporation. Generally, in the process of the thin film solar cell 200, after forming the first conductive layer 220, a first laser scanning process for patterning the first conductive layer 220 is used to form bottom electrodes of sub cells connected in series later. It is well-known to those with ordinary skills in the art and will not be described herein.

Thereafter, the photovoltaic layer 230 mentioned above is formed on the first conductive layer 220, as shown in FIG. 3B. In the present embodiment, a method of forming the photovoltaic layer 230, for example, includes radio frequency plasma enhanced chemical vapor deposition (RF PECVD), very high frequency plasma enhanced chemical vapor deposition (VHF PECVD, or microwave plasma enhanced chemical vapor deposition (MW PECVD). Wherein, the method of forming the photovoltaic layer 230 may be modified according to the film structure adopted by the thin film solar cell, such as the film structure of the above-described silicon thin film solar cell or II-VI compound semiconductor thin film solar cell. The above description is merely exemplary. Similarly, after forming the photovoltaic layer 230, a second laser scanning process for patterning the photovoltaic layer 230 is used. It is well-known to those with ordinary skills in the art and will not be described herein.

Thereafter, the second conductive layer 240 mentioned above is formed on the photovoltaic layer 230, as shown in FIG. 3B. In the present embodiment, a method of forming the second conductive layer 240 is similar to the method of forming the first conductive layer 220. It can be referred to the above description and will not be described herein. Similarly, after forming the second conductive layer 240, a third laser scanning process for patterning the second conductive layer 240 is used form top electrodes of the sub cells connected in series later. It is well-known to those with ordinary skills in the art and will not be described herein.

Next, the first passivation layer 250 mentioned above is formed on the second conductive layer 240, as shown in FIG. 3B. In the present embodiment, a method of forming the first passivation layer 250 includes a process of screen printing, dry film lamination, or spin coating. Herein, the process of screen printing is exemplary in detail below.

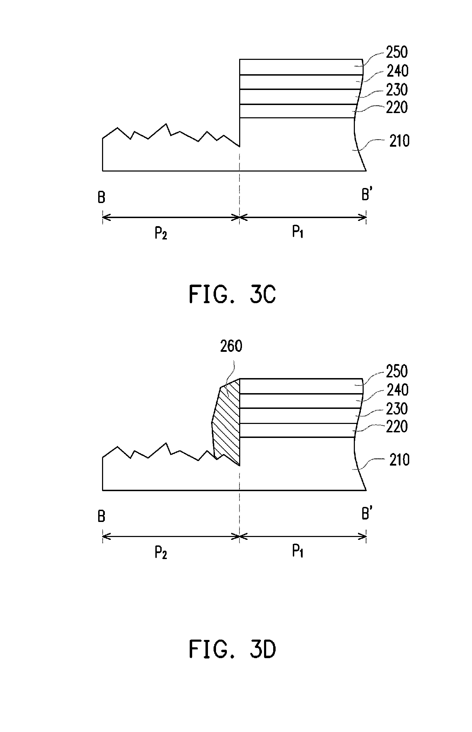

Thereafter, a portion of the first conductive layer 220, a portion of the photovoltaic layer 230, a portion of the second conductive layer 240, and a portion of the first passivation layer 250 located on a peripheral of the first substrate 210 are removed to define the above-described active region P1 and the above-described dead area P2 on the first substrate 210, as shown in FIG. 3C. In the present embodiment, a method of removing the above-described films 220, 230, 240, and 250 to define the active region P1 and the dead area P2, for example, is a process of etching, sandblasting, edging, or laser scribing or one of other suitable processes.

Next, the above-described second passivation layer 260 is formed and located in the dead area P2 to cover a peripheral of the photovoltaic layer 230 to avoid the photovoltaic layer 230 from contacting with moisture in air, as shown in FIG. 3D. In the present embodiment, a method of forming the second passivation layer 260 is similar to the method of forming the first passivation layer 250. It can be referred to the above description and will not be described herein.

Next, the above-described adhesion layer 270 is covered on the first passivation layer 250 and the second passivation layer 260 to package the above-described first substrate 210 and the above-described second substrate 280. Accordingly, the thin film solar cell 200 shown in FIG. 2B is formed. In the present embodiment, a method of packaging the first substrate 210 and the second substrate 280 by using the adhesion layer 270 is well-known to those with ordinary skilled in the art and will not be described herein. Thereby, the fabrication method of the thin film solar cell is approximately completed.

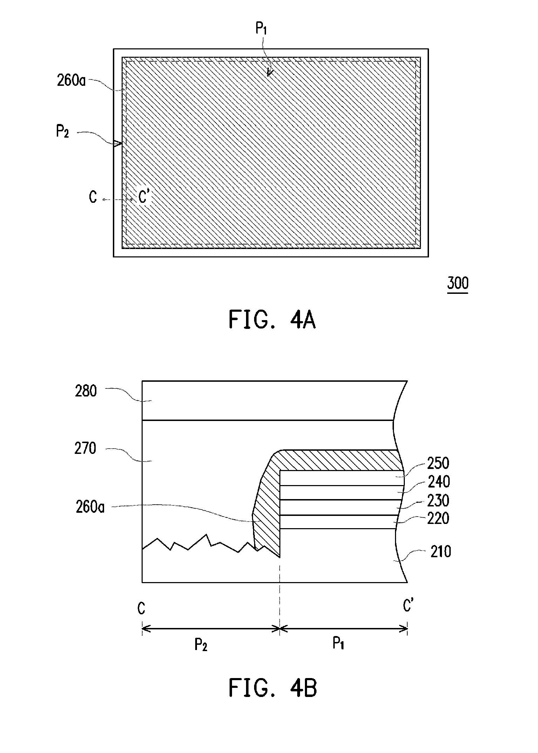

FIG. 4A is a top view of a thin film solar cell according to another embodiment consistent with the present invention. FIG. 4B is a cross-sectional view of the thin film solar cell along the line CC' in FIG. 4A. For convenience of description, FIG. 4A simply illustrates the top view of films on a first substrate in FIG. 4B but ignores a second substrate and an adhesion layer between the first substrate and the second substrate.

Referring to FIG. 2A, FIG. 2B, FIG. 4A, and FIG. 4B, the thin film solar cell 300 of the present embodiment is structurally similar to the thin film solar cell 200, and the same reference numbers refer to the same components. The difference between the two thin film solar cells 300 and 200 lies in that the second passivation layer 260a is disposed not only on the peripheral of the photovoltaic layer 240 and located in the dead area P2 but also on the first passivation layer 250 to further protect the films below the first passivation layer 250, as shown in FIG. 4A and FIG. 4B. In other words, the thin film solar cell 300 of the present embodiment also has the same advantages as that of the above-described thin film solar cell 200 do, and it will not be described herein.

It should be noted that, the method of forming the second passivation layer 260a is preferred to spin coating. As a result, not only a process period for forming the second passivation layer 260a but also a manufacturing period for the thin film solar cell 300 is reduced.

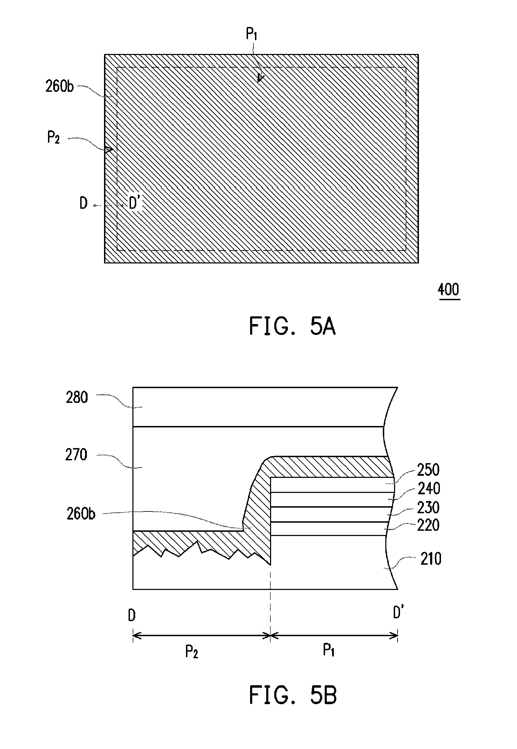

In another embodiment, the second passivation layer 260b may overall cover on the active area P1 and the dead area P2, so that the thin film solar cell 400 is formed as shown in FIG. 5A and FIG. 5B. FIG. 5A is a top view of a thin film solar cell according to another embodiment consistent with the present invention. FIG. 5B is a cross-sectional view of the thin film solar cell along the line DD' in FIG. 5A.

In the thin film solar cell 400, since film structure thereof is similar to that of the thin film solar cell 200 or 300 besides the second passivation layer 260b overall covers on the active area P1 and the dead area P2, the thin film solar cell 400 also has the same advantages as that of the above-described thin film solar cell 200 or 300 do, and it will not be described herein.

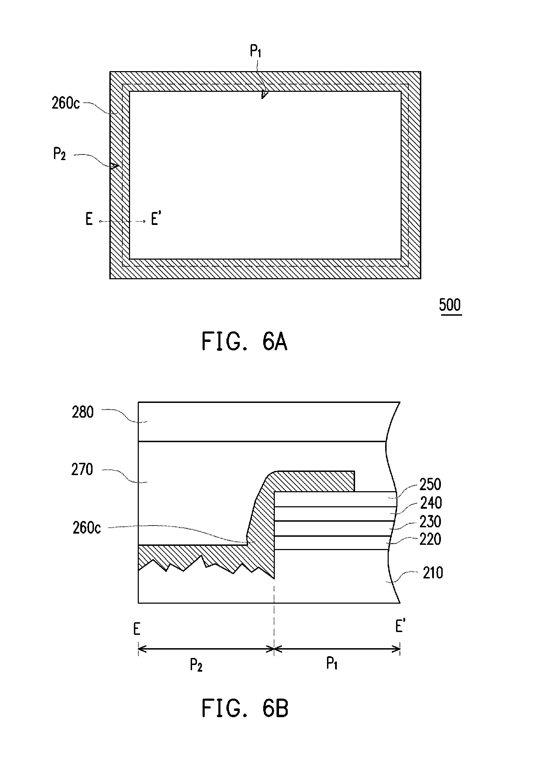

In another embodiment, the second passivation layer 260c may cover on a part of the active area P1 and the dead area P2, so that the thin film solar cell 500 is formed as shown in FIG. 6A and FIG. 6B. FIG. 6A is a top view of a thin film solar cell according to another embodiment consistent with the present invention. FIG. 6B is a cross-sectional view of the thin film solar cell along the line EE' in FIG. 6A.

In the thin film solar cell 500, since film structure thereof is similar to that of the thin film solar cell 200, 300 or 400 besides the second passivation layer 260b covers on a part of the active area P1 and the dead area P2, the thin film solar cell 500 also has the same advantages as that of the above-described thin film solar cell 200, 300, or 400 do, and it will not be described herein.

In view of the foregoing, the thin film solar cell and the fabrication method thereof is provided in the above-described embodiment. Since the thin film solar cell has the second passivation layer covering on the peripheral of the film structure composed of the first conductive layer, the photovoltaic layer, and the second conductive layer, leakage current or bad films, which may lower the electrical property of the thin film solar cell, due to infiltration of moisture in air are avoided. In other words, the thin film solar cell of the embodiment consistent with the present invention has a better electrical property. Moreover, the fabrication method of the thin film solar cell is also provided in the embodiment consistent with the present invention.

Although the present invention has been described with reference to the above embodiments, it will be apparent to one of the ordinary skill in the art that modifications to the described embodiment may be made without departing from the spirit of the invention. Accordingly, the scope of the invention will be defined by the attached claims not by the above detailed descriptions.

## Claims

1. A thin film solar cell, wherein the thin film solar cell has an active area and a dead area, comprising:
a first substrate;
a first conductive layer disposed on the first substrate and located in the active area;
an photovoltaic layer disposed on the first conductive layer and located in the active area;
a second conductive layer disposed on the photovoltaic layer and located in the active area;
a first passivation layer disposed on the second conductive layer and located in the active area; and
a second passivation layer disposed on a peripheral of the photovoltaic layer and located in the dead area to avoid the photovoltaic layer contacting moisture in air.

2. The thin film solar cell as claimed in claim 1, wherein a material of the second passivation layer is an insulating material.

3. The thin film solar cell as claimed in claim 1, further comprising a second substrate and an adhesion layer, wherein the adhesion layer covers the first passivation layer and the second passivation layer and is located between the first substrate and the second substrate to package the first substrate and the second substrate.

4. The thin film solar cell as claimed in claim 1, wherein a material of the adhesion layer comprises EVA, PVB, Poly Olefin, or PU.

5. The thin film solar cell as claimed in claim 1, wherein the photovoltaic layer is a silicon thin film, a III-V compound semiconductor thin film, a II-VI compound semiconductor thin film, or an organic compound semiconductor thin film.

6. The thin film solar cell as claimed in claim 5, wherein a material of the silicon thin film comprises at least one of a-Si, µc-Si, a-SiGe, µc-SiGe, a-SiC, and µc-SiC, and the silicon thin film is a tandem silicon thin film or a triple silicon thin film.

7. The thin film solar cell as claimed in claim 5, wherein a material of the III-V compound semiconductor thin film comprises GaAs, InGaP, or a combination thereof.

8. The thin film solar cell as claimed in claim 5, wherein a material of the II-VI compound semiconductor thin film comprises CIS, CIGS, CdTe, or a combination thereof.

9. The thin film solar cell as claimed in claim 5, wherein a material of the organic compound semiconductor thin film comprises Poly(3-hexylthiophene) ( P3HT) and a PCBM mixture.

10. The thin film solar cell as claimed in claim 1, wherein the first conductive layer is a transparent conductive layer, and the second conductive layer comprises one of a reflecting layer and a transparent conductive layer.

11. The thin film solar cell as claimed in claim 1, wherein the second conductive layer is a transparent conductive layer, and the first conductive layer comprises one of a reflecting layer and a transparent conductive layer.

12. A fabrication method of a thin film solar cell, comprising:
providing a first substrate;
forming a first conductive layer on the first substrate;
forming an photovoltaic layer on the first conductive layer;
forming a second conductive layer on the photovoltaic layer;
forming a first passivation layer on the second conductive layer;
removing a portion of the first conductive layer, a portion of the photovoltaic layer, a portion of the second conductive layer, and a portion of the first passivation layer located on a peripheral of the first substrate to define an active region and a dead area on the first substrate; and
forming a second passivation layer located in the dead area to cover a peripheral of the photovoltaic layer to avoid the photovoltaic layer contacting moisture in air.

13. The fabrication method of the thin film solar cell as claimed in claim 12, further comprising: covering an adhesion layer on the first passivation layer and the second passivation layer to package the first substrate and a second substrate.

14. The fabrication method of the thin film solar cell as claimed in claim 12, wherein a method of forming the first passivation layer and the second passivation layer comprises a process of screen printing, dry film lamination, or spin coating.

15. The fabrication method of the thin film solar cell as claimed in claim 12, wherein a method of defining the active region and the dead area on the first substrate comprises a process of etching, sandblasting, edging, or laser scribing.
